# EUROPEAN PATENT APPLICATION

(11) **EP 4 811 041 A1**
(43) Date of publication of application: **23.09.2026**
(21) Application number: 26166009.6
(22) Date of filing: 19.03.2026
(51) Int. Cl.: G03F 7/20, G03F 9/00, G03F 7/00

(54) **IMPRINT METHOD, IMPRINT APPARATUS, AND ARTICLE MANUFACTURING METHOD**

(30) Priority: 21.03.2025 JP 2025047268
(71) Applicant: Canon Kabushiki Kaisha, Tokyo 146-8501 (JP)
(72) Inventor: INUI, Ryutaro, Ohta-ku, Tokyo, 146-8501 (JP); MOROHOSHI, Hiroshi, Ohta-ku, Tokyo, 146-8501 (JP)
(74) Representative: TBK

(57) **Abstract**

Imprint processing is performed for each of shot regions that can be classified into first type enabling use of predetermined number of alignment marks and second type disabling use of the predetermined number of alignment marks. Method includes controlling imprint processing sequence to alternately execute imprint processing for the first type and the second type, performing first imprint process of measuring alignment error, with respect to the first type, between the shot region and pattern region of mold by using the predetermined number of alignment marks and performing the imprint processing based on the alignment error, and performing second imprint process of performing the imprint processing for the second type based on alignment error between the shot region and the pattern region by using usable alignment marks and the alignment error obtained in the latest first imprint process.

## Description

### TECHNICAL FIELD

The present disclosure relates to an imprint method, an imprint apparatus, and an article manufacturing method.

### BACKGROUND

Japanese Patent Laid-Open No. 2013-138175 discloses an imprint apparatus that performs the imprint processing of molding an imprint material on a substrate by using a mold having a pattern region in which a pattern is formed and transferring the pattern onto the substrate. The substrate includes a plurality of shot regions. The plurality of shot regions include first shot regions in each of which all the marks to be formed in one shot region are formed and second shot regions in each of which some of all the marks to be formed in one shot region are not formed. The first shot region can be called a full field. The second shot region can be called a partial field or deficient field. The imprint apparatus disclosed in Japanese Patent Laid-Open No. 2013-138175 performs imprint processing for the second shot regions after performing imprint processing for all the first shot regions. When performing imprint processing for the second shot region, the imprint apparatus calculates the shape of the second shot region based on the result of detecting the marks formed in the first shot region and controls the deformation amount of the pattern region of the mold based on the shape.

In a case where imprint processing is performed for the second shot regions after imprint processing is performed for all the first shot regions as described above, the state of the imprint apparatus can change depending on the time elapsed since the detection of the marks formed in the first shot regions. For this reason, the alignment error between the second shot region and the pattern region of the mold can increase depending on the time elapsed since the detection of the marks formed in the first shot regions.

### SUMMARY

The present disclosure provides a technique advantageous in improving alignment accuracy.

The present disclosure in its first aspect provides an imprint method as specified in claim 1. Optional features are specified in claim 2 to 12.

The present disclosure in its second aspect provides an imprint method as specified in claim 13. Optional features are specified in claim 14 to 22.

The present disclosure in its third aspect provides an imprint apparatus as specified in claim 23.

The present disclosure in its fourth aspect provides an imprint apparatus as specified in claim 24.

The present disclosure in its fifth aspect provides an article manufacturing method as specified in claim 25.

Features of the present disclosure will become apparent from the following description of embodiments with reference to the attached drawings. The following description of embodiments is described by way of example.

### BRIEF DESCRIPTION OF THE DRAWINGS

Fig. 1 is a schematic view showing the configuration of an imprint apparatus according to one embodiment;
Fig. 2 is a view showing a configuration example of a correction mechanism;
Fig. 3A is a view showing the pattern region of a mold;
Fig. 3B is a view showing shot regions of a substrate;
Fig. 4A is a view showing a shift component of the alignment error between a shot region and a pattern region;
Fig. 4B is a view showing a magnification component of the alignment error between the shot region and the pattern region;
Fig. 4C is a view showing a trapezoidal component (deformation component) of the alignment errors between the shot region and the pattern region;
Fig. 4D is a view showing a distortion component (deformation component) of the alignment error between the shot region and the pattern region;
Fig. 4E is a view showing a rotation component of the alignment error between the shot region and the pattern region;
Fig. 5A is a view showing a partial field as an example of a second type shot region disabling the use of a predetermined number of alignment marks;
Fig. 5B is a view showing a shot region which is a full field but has defects (for example, foreign substances) in one or more alignment marks as another example of a second type shot region where a predetermined number of alignment marks cannot be used;
Fig. 6 is a flowchart showing a procedure in an imprint method executed in an imprint apparatus;
Fig. 7 is a view showing the arrangement of a plurality of shot regions of a substrate;
Fig. 8 is a view schematically showing a state in which a correction mechanism deforms the pattern region of a mold so as to reduce alignment errors using a correction mechanism;
Fig. 9 is a view showing a first control example in the first imprint step and the second imprint step;
Fig. 10 is a view showing a second control example in (the first imprint step) and the second imprint step;
Fig. 11 is a view schematically showing a state in which a substrate driving mechanism rotates and moves a substrate so as to reduce the alignment error;
Fig. 12 is a view showing a first control example in the first imprint step and the second imprint step;
Fig. 13 is a view showing a second control example in the first imprint step and the second imprint step;
Figs. 14A to 14F are views showing an article manufacturing method; and
Figs. 15A to 15D are views showing another article manufacturing method.

### DESCRIPTION OF THE EMBODIMENTS

Hereinafter, embodiments will be described in detail with reference to the attached drawings. Note, the following embodiments are not intended to limit the scope of the claims. Multiple features are described in the embodiments, but it is not the case that all such features are required, and multiple such features may be combined as appropriate. Furthermore, in the attached drawings, the same reference numerals are given to the same or similar configurations, and redundant description thereof is omitted.

### (First Embodiment)

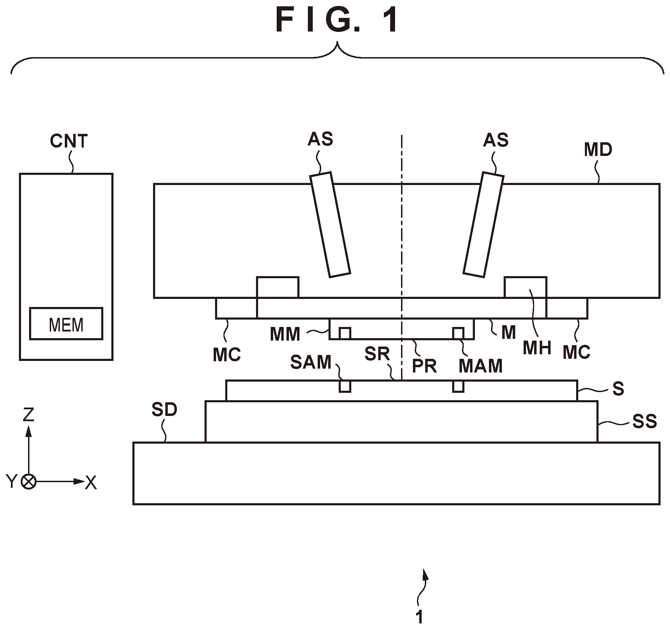

Fig. 1 is a schematic view showing the configuration of an imprint apparatus 1 according to one embodiment. The imprint apparatus 1 is a lithography apparatus that is used in a manufacturing process for an article such as a semiconductor device. The imprint apparatus 1 performs imprint processing for each shot region SR of a substrate S having a plurality of shot regions SR by using a mold M. Imprint processing includes bringing a pattern region PR of the mold M into contact with the shot region SR of the substrate S through an imprint material, aligning the shot region SR with the pattern region PR, curing the imprint material, and separating the pattern region PR from the cured imprint material. The imprint material may be applied onto the shot region SR by a dispenser (not shown) in the imprint apparatus 1 or may be applied onto the shot region SR from outside the imprint apparatus 1.

In the specification and the accompanying drawings, directions will be indicated on an XYZ coordinate system in which directions parallel to the surface of the substrate S are defined as the X-Y plane. Directions parallel to the X-axis, the Y-axis, and the Z-axis of the XYZ coordinate system are the X direction, the Y direction, and the Z direction, respectively. A rotation about the X-axis, a rotation about the Y-axis, and a rotation about the Z-axis are θX, θY, and θZ, respectively. Control or driving concerning the X-axis, the Y-axis, and the Z-axis means control or driving concerning a direction parallel to the X-axis, a direction parallel to the Y-axis, and a direction parallel to the Z-axis, respectively. Control or driving concerning the θX-axis, the θY-axis, and the θZ-axis means control or driving concerning a rotation about an axis parallel to the X-axis, a rotation about an axis parallel to the Y-axis, and a rotation about an axis parallel to the Z-axis, respectively. In addition, a position is information that can be specified based on coordinates on the X-, Y-, and Z-axes, and a posture is information that can be specified by values on the θX-, θY-, and θZ-axes. Positioning means controlling the position and/or posture. Alignment can include controlling the position and/or posture of at least one of the substrate S and the mold M such that the alignment error (overlay error) between the shot region SR of the substrate S and the pattern region PR of the mold M decreases. Alignment may include control to correct or change the shape of at least one of the shot region SR of the substrate S and the pattern region PR of the mold M.

As the imprint material, a curable composition (to be also referred to as a resin in an uncured state hereinafter) to be cured by receiving curing energy is used. As the curing energy, electromagnetic waves, heat, or the like can be used. As the electromagnetic waves, light such as infrared light, visible light, or ultraviolet light selected from the wavelength range of 10 nm (inclusive) to 1 mm (inclusive) can be used. The curable composition can be understood as a composition cured by light irradiation or heating. Among these, the photo-curable composition cured by light irradiation contains at least a polymerizable compound and a photopolymerization initiator, and may contain a nonpolymerizable compound or a solvent, as needed. The nonpolymerizable compound is at least one type of material selected from a group consisting of a sensitizer, a hydrogen donor, an internal mold release agent, a surfactant, an antioxidant, a polymer component, and the like. The imprint material may be arranged on the substrate in the form of droplets or in the form of an island or film formed by connecting a plurality of droplets. In addition, the imprint material may be supplied in the form of a film on the substrate by a spin coater or slit coater. The viscosity (the viscosity at 25°C) of the imprint material can be, for example, 1 mPa·s (inclusive) to 100 mPa·s (inclusive). As substrate materials, for example, glass, ceramics, metals, semiconductors (Si, GaN, SiC, and the like), resins, and the like can be used. A surface of a substrate may be provided with a member made of a material different from that of the substrate, as needed. The substrate S is, for example, a silicon wafer, a compound semiconductor wafer, or a silica glass wafer. The substrate S may have one or a plurality of layers on a semiconductor substrate or non-semiconductor substrate. Each shot region SR of the substrate S has a plurality of alignment marks SAM.

The imprint apparatus 1 can include a mold holding unit MH that holds the mold M, a mold driving mechanism MD that drives the mold M by driving the mold holding unit MH, a substrate stage SS that holds the substrate S, and a substrate driving mechanism SD that drives the substrate S by driving the substrate stage SS. The imprint apparatus 1 can include one or a plurality of alignment scopes AS for measuring the alignment error between the selected shot region SR of the substrate S and the pattern region PR of the mold M and a correction mechanism MC that corrects the shape of the shot region SR. The imprint apparatus 1 can also include a controller CNT that controls each constituent element of the imprint apparatus 1. The controller CNT is implemented by, for example, a programmable logic device (PLD) such as a field programmable gate array (FPGA), an application specific integrated circuit (ASIC), a general-purpose or dedicated computer installed with a program, or a combination of all or some of them.

The pattern region PR of the mold M has a pattern to be transferred onto the shot region SR of the substrate S (the imprint material on the shot region SR from another viewpoint). The mold M can have a mesa MM. The mesa MM can have the pattern region PR. The mold M can be made of a material (for example, quartz) that transmits curing energy (for example, ultraviolet light) for curing an imprint material on the substrate S. The pattern region PR of the mold M has a plurality of alignment marks MAM. The mold holding unit MH can hold the mold M by vacuum suction or electrostatic suction. The mold driving mechanism MD can be configured to drive the mold holding unit MH with respect to a plurality of axes (for example, three axes including the Z-axis, θX-axis, and θY-axis, and preferably six axes including the X-axis, Y-axis, Z-axis, θX-axis, θY-axis, and θZ-axis). The correction mechanism MC can correct or control the shape of the pattern region PR of the mold M by, for example, applying force to a side surface of the mold M and/or heating the mold M. The substrate driving mechanism SD can be configured to drive the substrate S with respect to a plurality of axes (for example, three axes including the X-axis, Y-axis, and θZ-axis, and preferably six axes including the X-axis, Y-axis, Z-axis, θX-axis, θY-axis, and θZ-axis).

The alignment scope AS can be used to measure the positional shift amount (alignment error) between the alignment mark MAM provided in the pattern region PR of the mold M and the alignment mark SAM provided in the shot region SR of the substrate S. The pattern region PR of the mold M has a plurality of alignment marks MAM. The shot region SR of the substrate S has a plurality of alignment marks SAM. The controller CNT can detect images of the alignment marks MAM and SAM by using the alignment scope AS, measure the position of the alignment mark MAM and the position of the alignment mark SAM based on the images, and measure the positional shift amount between them. Alternatively, the controller CNT may capture images (moire images) formed by the alignment marks MAM and SAM by using the alignment scope AS and measure the positional shift amount between the alignment marks MAM and SAM based on the images. The controller CNT can measure the positional shift of each of a plurality of alignment marks by using the alignment scope AS and obtain the alignment error between the shot region SR and the pattern region PR based on these measurement results. The alignment error can include, for example, at least one error among the shift component, rotation component, magnification component, and deformation component between the shot region SR and the pattern region PR. Each alignment mark pair can be constituted by the alignment marks MAM and SAM. The imprint apparatus 1 may include a plurality of alignment scopes AS and capture images of a plurality of alignment mark pairs in parallel by using the plurality of alignment scopes AS.

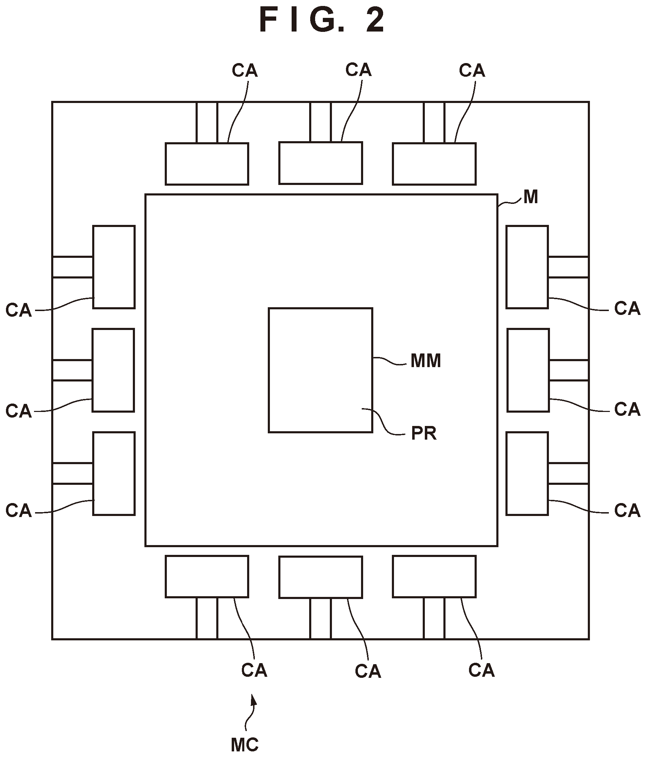

Fig. 2 shows a configuration example of the correction mechanism MC. The correction mechanism MC can deform the pattern region PR so as to reduce the alignment error between the pattern region PR and the shot region SR or make the alignment error fall within an allowable range. The correction mechanism MC can include a plurality of correction actuators CA that apply a force to a side surface of the mold M. Each correction actuator CA is configured to apply a pressing force to a side surface of the mold M or apply a pressing force or pulling force to a side surface of the mold M. Alternatively, the correction mechanism MC can be configured to form a heat distribution on the mold M.

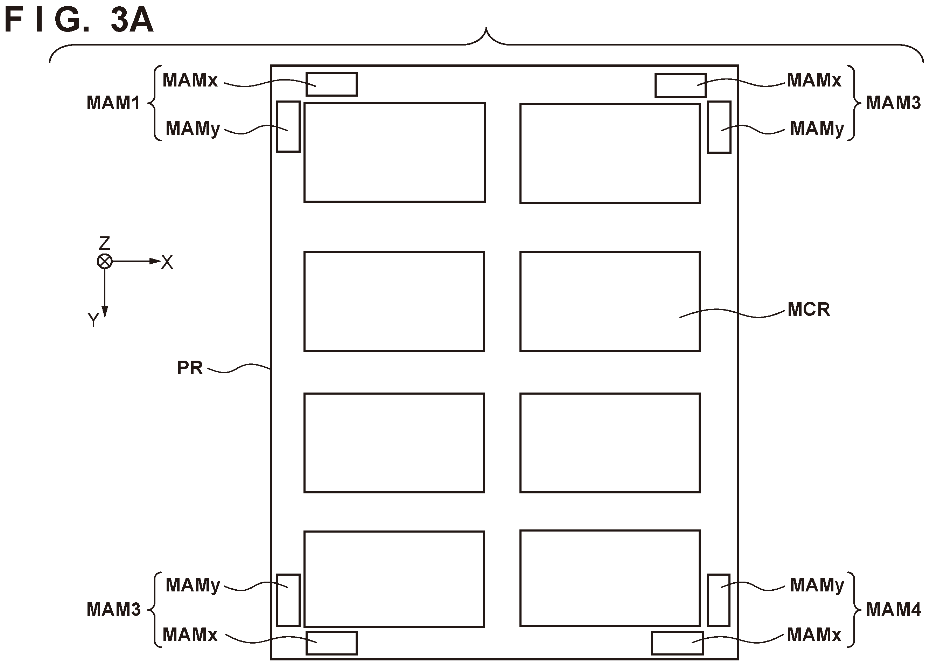

Fig. 3A shows the pattern region PR of the mold M. The pattern region PR has the plurality of alignment marks MAM, for example, four alignment marks MAM1 to MAM4. The plurality of alignment marks MAM can be arranged, for example, at the four corners of the pattern region PR. Each alignment mark MAM can include a first mark MAMx for detecting an alignment error in the first direction (X direction) and a second mark MAMy for detecting an alignment error in the second direction (Y direction) orthogonal to the first direction. The pattern region PR can include a plurality of chip regions MCR.

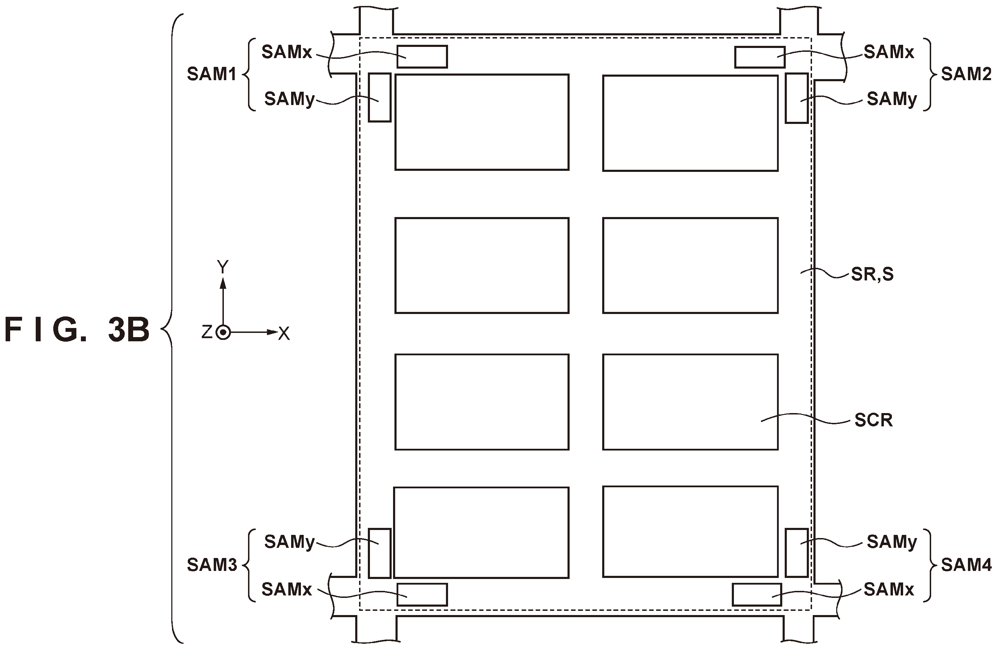

Fig. 3B shows the shot region SR of the substrate S. Each shot region SR can have the plurality of alignment marks SAM, for example, four alignment marks SAM1 to SAM4. The plurality of alignment marks SAM can be arranged at the four corners of each shot region SR. Each alignment mark SAM can include a first mark SAMx for detecting an alignment error in the first direction (X direction) and a second mark SAMy for detecting an alignment error in the second direction (Y direction) orthogonal to the first direction. The shot region SR can include a plurality of chip regions SCR.

In the case shown in Figs. 3A and 3B, the alignment mark MAM1 of the pattern region PR and the alignment mark SAM1 of the shot region SR constitute one alignment mark pair. The alignment mark MAM2 of the pattern region PR and the alignment mark SAM2 of the shot region SR constitute one alignment mark pair. The alignment mark MAM3 of the pattern region PR and the alignment mark SAM3 of the shot region SR constitute one alignment mark pair. The alignment mark MAM4 of the pattern region PR and the alignment mark SAM4 of the shot region SR constitute one alignment mark pair.

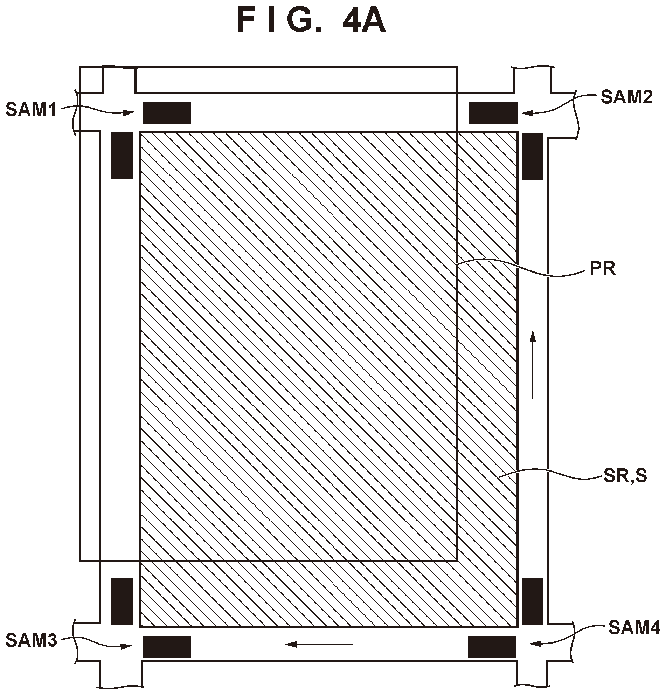

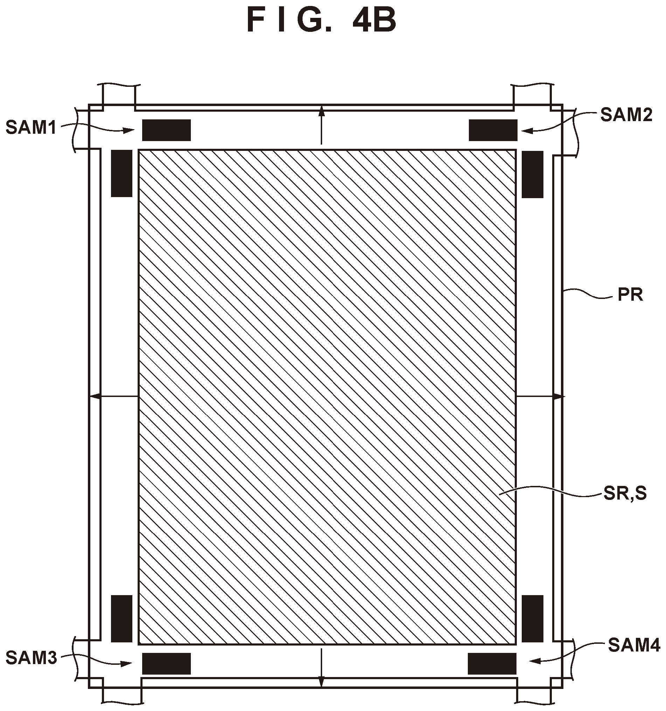

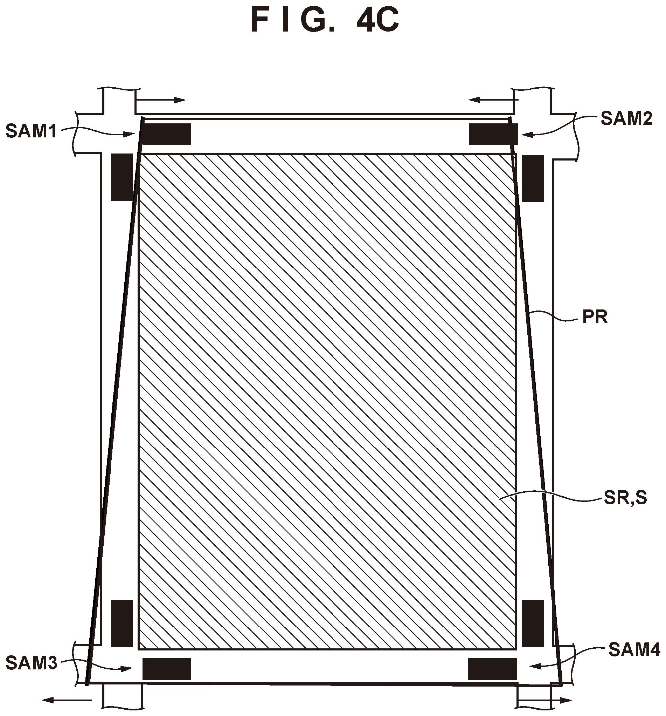

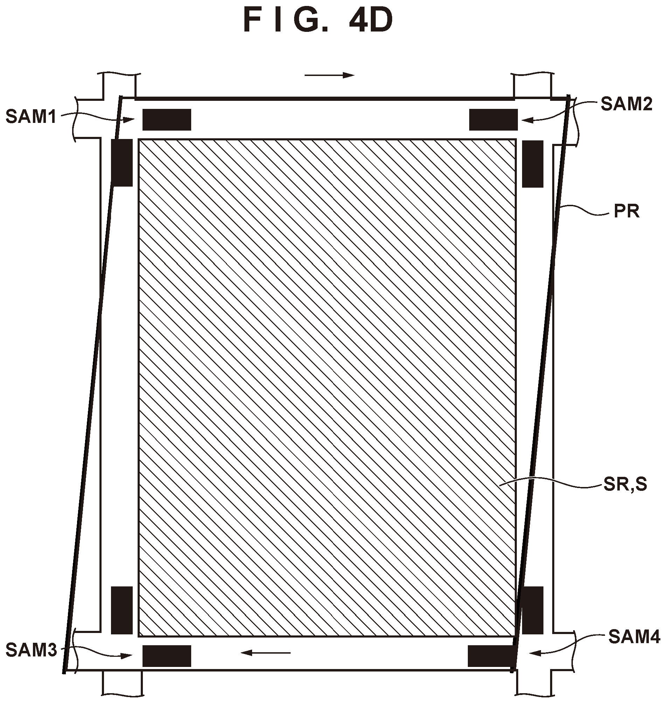

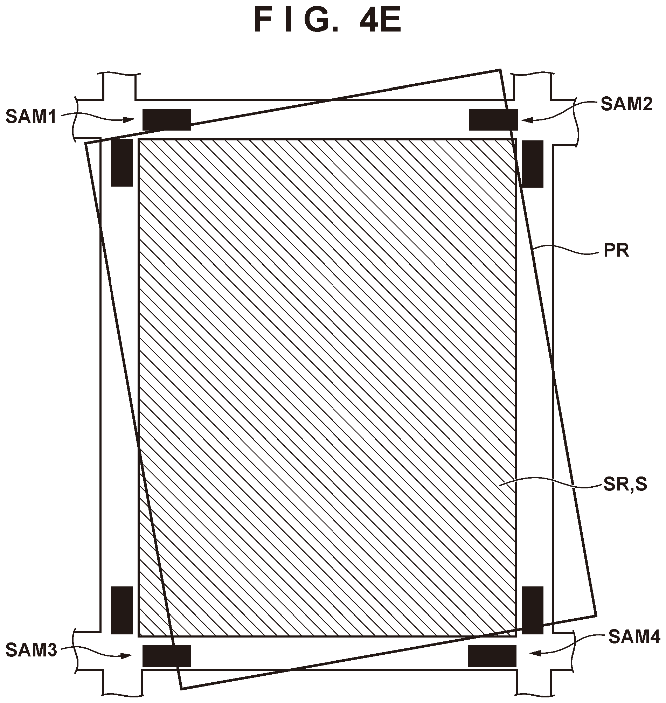

Figs. 4A, 4B, 4C, 4D, and 4E each show a component of the alignment error between the shot region SR of the substrate S and the pattern region PR of the mold M. It is possible to determine each component of the alignment error between the shot region SR and the pattern region PR by measuring the positional shift amount between the alignment mark SAM and the alignment mark MAM of each of a plurality of alignment mark pairs.

Fig. 4A shows a shift component of the alignment error between the shot region SR and the pattern region PR. In a case where the alignment marks MAM1 to MAM4 of the pattern region PR each shift in a common direction with respect to a corresponding one of the alignment marks SAM1 to SAM4 of the shot region SR, the alignment error between the shot region SR and the pattern region PR can include a shift component.

Fig. 4B shows a magnification component of the alignment error between the shot region SR and the pattern region PR. In a case where the alignment marks MAM1 to MAM4 of the pattern region PR shift in the outward or inward direction with respect to the alignment marks SAM1 to SAM4 of the shot region SR, the alignment error between the shot region SR and the pattern region PR can include a magnification component.

Fig. 4C shows a trapezoidal component (deformation component) of the alignment error between the shot region SR and the pattern region PR. In the case shown in Fig. 4C, the alignment marks MAM1 to MAM4 of the pattern region PR shift in the outward or inward direction with respect to the alignment marks SAM1 to SAM4 of the shot region SR, and the shifting direction differs on the upper and lower sides or left and right sides of the shot region. In this case, the alignment error between the shot region SR and the pattern region PR can include a trapezoidal component.

Fig. 4D shows a distortion component (deformation component) of the alignment error between the shot region SR and the pattern region PR. In the case shown in Fig. 4D, the shifting direction of the alignment marks MAM1 to MAM4 of the pattern region PR with respect to the alignment marks SAM1 to SAM4 of the shot region SR differs on the upper and lower sides or left and right sides of the shot region. In this case, the alignment error between the shot region SR and the pattern region PR can include a distortion component.

Fig. 4E shows a rotation component of the alignment error between the shot region SR and the pattern region PR. In the case shown in Fig. 4E, the shifting direction of the alignment marks MAM1 to MAM4 of the pattern region PR with respect to the alignment marks SAM1 to SAM4 of the shot region SR differs on the upper and lower sides or left and right sides of the shot region. In this case, the alignment error between the shot region SR and the pattern region PR can include a rotation component.

As shown in Figs. 4B, 4C, and 4D, in a case where the alignment error between the shot region SR and the pattern region PR includes a magnification component, a trapezoidal component, and distortion component, the controller CNT can cause a correction mechanism MC to deform the pattern region PR. In this case, the controller CNT can cause the correction mechanism MC to deform the pattern region PR so as to reduce the alignment error. The controller CNT can acquire, in advance, data indicating the relationship between a command value for each correction actuator CA and the deformation amount of the pattern region PR and store the acquired data in a memory MEM. The controller CNT then can determine a command value to be provided to each correction actuator CA to reduce the alignment error measured by using the alignment scope AS based on the measured alignment error. As shown in Figs. 4A and 4E, in a case where the alignment error between the shot region SR and the pattern region PR includes a shift component and a rotation component, the controller CNT can control the substrate driving mechanism SD so as to, for example, reduce the alignment error.

In the imprint apparatus 1, in order to improve the productivity by obtaining more chips from one substrate S, a pattern can be formed in not only a shot region having a rectangular shape but also a shot region having a shape including an arc along an edge of the substrate S by imprint processing. A shot region having a rectangular shape can also be called a full field. A shot region having a shape including an arc along an edge of the substrate S can also be called a partial field or deficient field. Focusing on the number of the alignment marks SAM of the shot region SR, a shot region (full field) having a rectangular shape can be classified as a first type shot region enabling the use of a predetermined number (for example, four) of alignment marks. Focusing on the number of the alignment marks SAM of the shot region SR, a shot region (a partial field or deficient field) having a shape including an arc can be classified as a second type shot region disabling the use of the predetermined number of alignment marks. Even a shot region (full field) having a rectangular shape sometimes disables the use of a predetermined number of alignment marks because the region has one or more alignment marks having a defect (for example, the adhesion of a foreign substance). Such a shot region can be classified as a second type shot region disabling the use of the predetermined number of alignment marks.

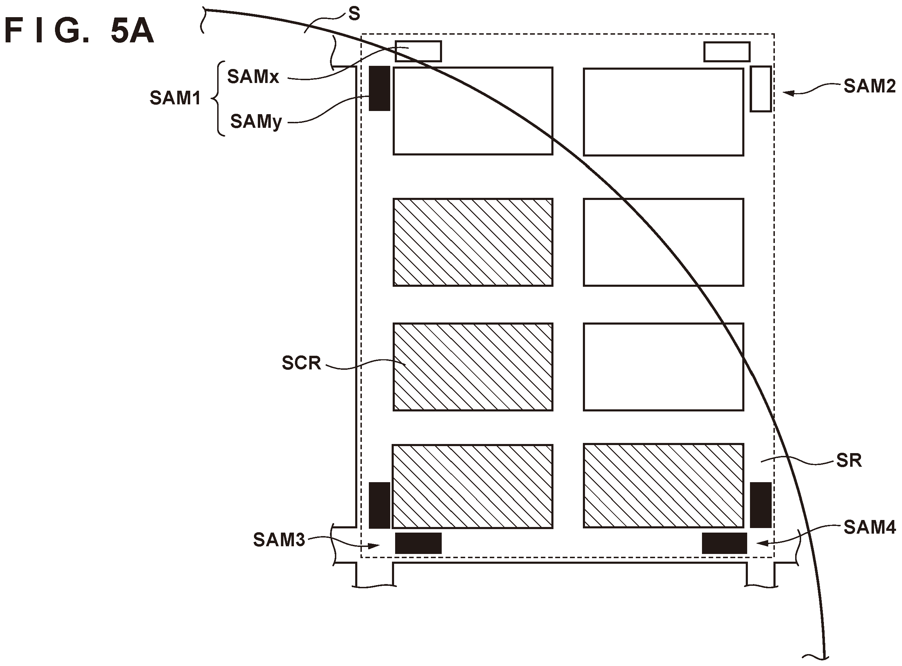

Fig. 5A shows a partial field, that is, the shot region SR having a shape including an arc along an edge of the substrate S as an example of a second type shot region disabling the use of a predetermined number of alignment marks. Referring to Fig. 5A, a chip region SCR with hatching is an example of the chip region SCR in which a pattern can be formed and which is used as a chip. Referring to Fig. 5A, a region indicated by a white frame is not a chip region. Note that in the case shown in Fig. 5A, the second mark SAMy among the first mark SAMx and the second mark SAMy constituting the alignment mark SAM1 is located as a whole within an edge of the substrate S and hence can be used. In contrast, the first mark SAMx among the first mark SAMx and the second mark SAMy constituting the alignment mark SAM1 is not located as a whole within an edge of the substrate S and hence cannot be used. In such a case, it may be allowed to use an algorithm that regards the alignment mark SAM1 as a usable alignment mark or an algorithm that does not regard the alignment mark SAM1 as a usable alignment mark. The following will describe a case where both the first mark SAMx and the second mark SAMy are regarded as the usable alignment mark SAM.

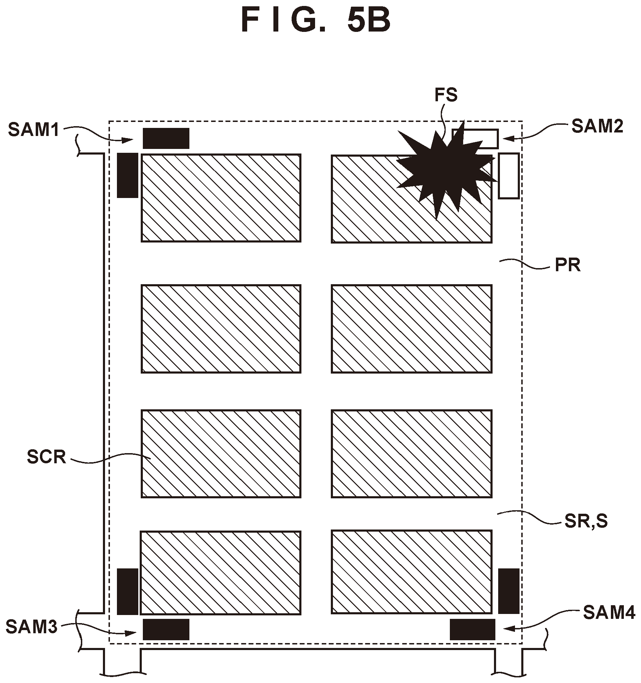

Fig. 5B shows the shot region SR that is a full field but has a defect (for example, a foreign substance FS) in one or more alignment marks as another example of a second type shot region disabling the use of a predetermined number of alignment marks. Referring to Fig. 5B, the chip region SCR with the hatching is an example of the chip region SCR that can be used as a chip on which a pattern can be formed.

As described above, the substrate S has the plurality of shot regions SR that can be classified into first type shot regions each enabling the use of a predetermined number of alignment marks and second type shot regions each disabling the use of the predetermined number of alignment marks. The imprint apparatus 1 according to the first embodiment and the imprint method executed by the imprint apparatus 1 perform imprint processing by using the mold M on each shot region SR of the substrate S. In the first embodiment, in a first type shot region, an alignment error (the alignment error between the first type shot region and the pattern region) can be measured by using a predetermined number of alignment marks, and it is possible to execute the first imprint step of performing imprint processing based on the alignment error. In contrast to this, in a second type shot region, it is possible to execute the second imprint step of performing imprint processing based on the result of measuring an alignment error (the alignment error between the second type shot region and the pattern region) by using usable alignment marks and the alignment error obtained in at least the latest first imprint step. In this case, at least the latest first imprint step is, for example, the latest first imprint step, that is, the first imprint step executed at the execution time closest to the current execution time of the second imprint step.

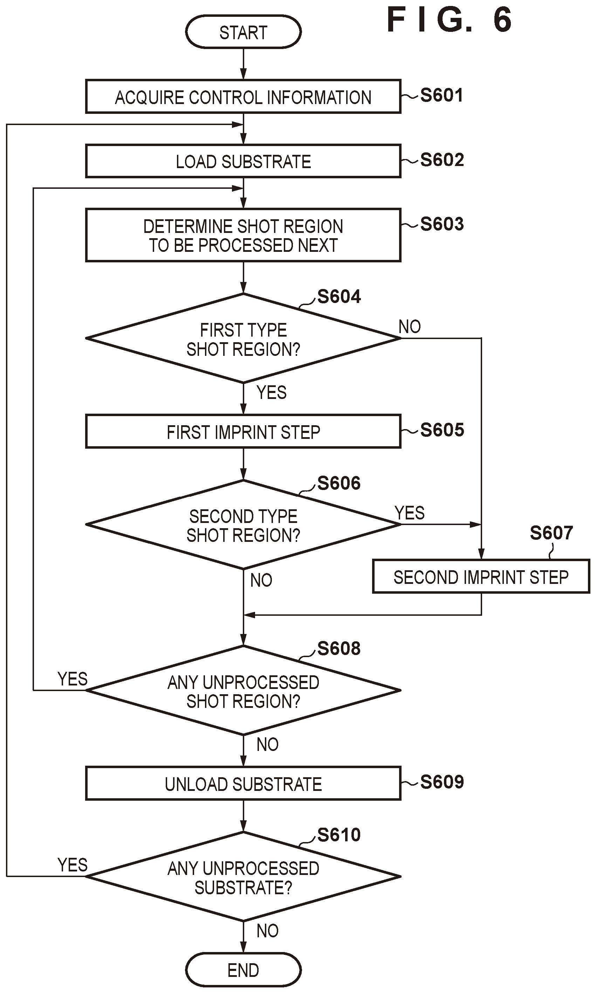

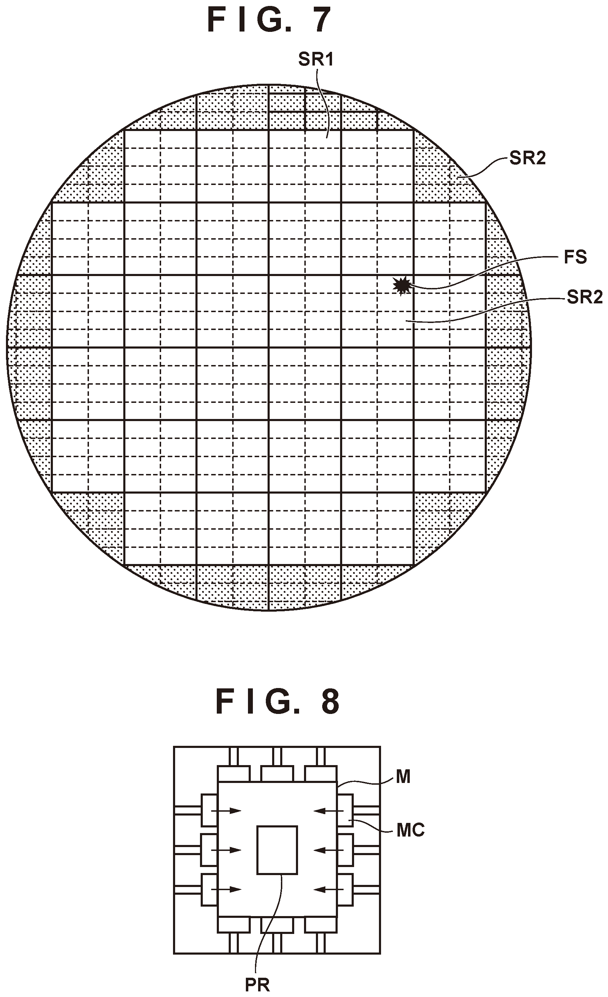

Fig. 6 shows a procedure in the imprint method executed by the imprint apparatus 1. The controller CNT controls the imprint method shown in Fig. 6. Assume a case where the imprint method is executed for the substrate S shown in Fig. 7. Referring to Fig. 7, shot regions (full fields) each having a rectangular shape are partitioned by the thick lines and indicated by rectangular regions without any dot pattern. Among the shot regions (full fields) each having a rectangular shape, shot regions without any defect such as the foreign substance FS affecting an alignment step are first type shot regions SR1. Among the shot regions (full fields) each having a rectangular shape, a shot region having a defect such as the foreign substance FS affecting an alignment step is a second type shot region SR2. Referring to Fig. 7, shot regions (partial fields) each attached with a dot pattern and having a shape including an arc are the second type shot regions SR2.

In step S601, the controller CNT can acquire control information (recipe information) for controlling an imprint job from a high-level controller (not shown) or the like. The control information can include, for example, sequence information indicating a sequence of executing imprint processing for the plurality of shot regions SR of the substrate S. The sequence information can be information that defines the alternate execution of imprint processing for at least one first type shot region and imprint processing for at least one second type shot region. A first type shot region in the sequence information can be a shot region (full field) having a rectangular shape, and a second type shot region can be a shot region (partial field) having a shape including an arc. However, in a case where an alignment mark that cannot be used because of the presence of a foreign substance or the like has already been specified, second type shot regions can include a shot region having an alignment mark that cannot be used because of the presence of a foreign substance or the like.

In step S602, the controller CNT loads the substrate S on the substrate stage SS by controlling a transfer mechanism (not shown). In step S603, the controller CNT determines a shot region to be processed next based on control information (sequence information). In this case, the controller CNT determines a shot region to be processed next so as to alternately execute imprint processing for at least one first type shot region and imprint processing for at least one second type shot region based on control information (sequence information). Step S603 is a sequence control step of controlling a sequence of imprint processing for a plurality of shot regions so as to alternately execute imprint processing for at least one first type shot region and imprint processing for at least one second type shot region. Step S603 (sequence control step) can be understood as a step of controlling a sequence of imprint processing for a plurality of shot regions in accordance with a tentative sequence (sequence information) determined in advance.

In step S604, the controller CNT determines whether a shot region to be processed next is a shot region classified as a first type shot region or a shot region classified as a second type shot region. If the shot region to be processed next is a shot region classified as a first type shot region, the controller CNT executes step S605. If the shot region to be processed next is a shot region classified as a second type shot region, the controller CNT executes step S607.

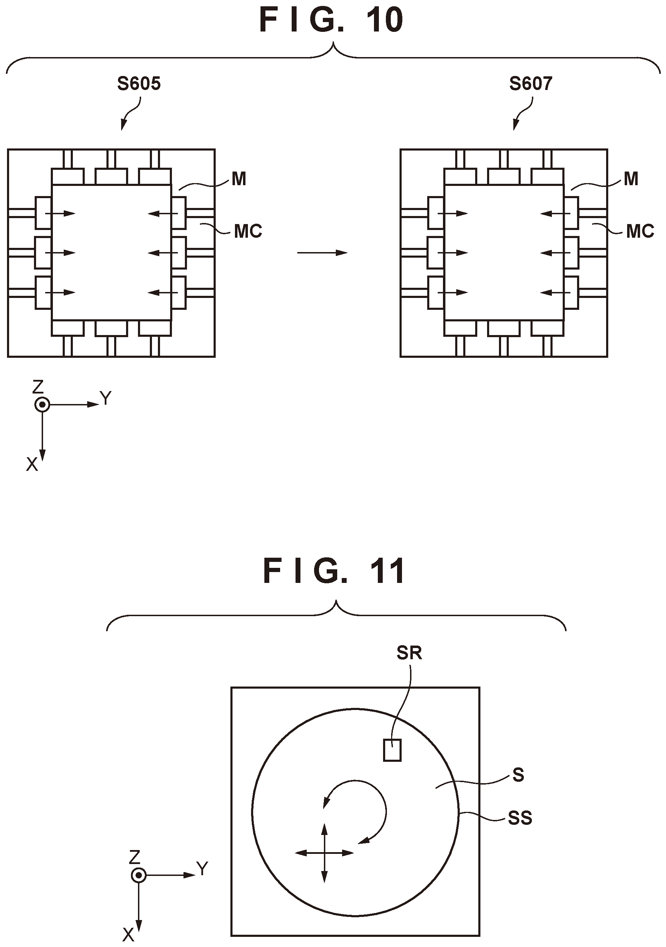

In step S605, the controller CNT executes the first imprint step of performing imprint processing for the shot region classified as the first type shot region. In the first imprint step, the controller CNT measures the alignment error between the shot region (the first type shot region) using a predetermined number of alignment marks and the pattern region PR of the mold M and performs imprint processing based on the alignment error. The imprint processing can include a contact step of bringing the pattern region PR of the mold M into contact with the shot region SR (first type shot region) through an imprint material and an alignment step of performing alignment between the shot region SR and the pattern region PR. The imprint processing can also include a curing step of forming a cured product of the imprint material by curing the imprint material by applying curing energy to the imprint material on the shot region SR and a separation step of separating the pattern region PR of the mold M from the cured product. The imprint processing may include a coating step of supplying or applying an imprint material onto the shot region SR before a contact step by using a dispenser (not shown). In the alignment step, the controller CNT can measure the alignment error between the shot region SR and the pattern region PR of the mold M by using a predetermined number of alignment marks and control the correction mechanism MC and the substrate driving mechanism SD so as to reduce the alignment error. Fig. 8 schematically shows how the correction mechanism MC deforms the pattern region PR of the mold M in step S605 so as to reduce the alignment error. Fig. 11 schematically shows how the substrate driving mechanism SD rotates and moves the substrate (the substrate stage SS) in step S605 so as to reduce the alignment error. In step S605, the controller CNT can store, in a memory MEM, a final first correction command value group applied to the correction mechanism MC and a final second correction command value group applied to the substrate driving mechanism SD to reduce the alignment error.

In an alignment step, for example, the alignment scope AS may fail to properly capture an image or images of one or two or more of a plurality of alignment mark pairs. This may make it impossible to use a predetermined number of alignment mark pairs. If a predetermined number of alignment mark pairs cannot be used, the shot region SR (more specifically, the shot region that has been classified as a first type shot region and a processing target in the first imprint step) is processed as a second type shot region. In step S606, the controller CNT determines whether a shot region to be subjected to imprint processing next is a second type shot region disabling the use of a predetermined number of alignment mark pairs. If the shot region as the current processing target is a second type shot region, the controller CNT executes step S607; otherwise, executes step S608. Step S606 can be understood as a determination step of determining whether a shot region to be subjected to imprint processing next is a first type shot region enabling the use of a predetermined number of alignment marks or a second type shot region disabling the use of the predetermined number of alignment marks.

In step S607, the controller CNT executes the second imprint step of performing imprint processing for a shot region classified as a second type shot region. In the second imprint step, the controller CNT performs imprint processing based on the result of measuring the alignment error between the shot region and the pattern region PR (more specifically, the alignment error between a second type shot region and the pattern region) using usable alignment marks and the alignment error obtained in at least the latest first imprint step. This makes it possible to perform alignment with high alignment accuracy even for a second type shot region.

In step S608, the controller CNT determines whether there is any unprocessed shot region. If there is any unprocessed shot region, the process returns to step S603; otherwise, advances to step S609. If the process returns to step S603 through steps S607 and S608, the controller CNT may select a first type shot region as a shot region to be processed next. That is, in step S603 (sequence control step), the controller CNT can control a sequence of imprint processing so as to execute imprint processing for a shot region having a predetermined number of alignment marks next to imprint processing for a second type shot region (more specifically, a shot region that has not allowed the use of a predetermined number of alignment marks for the measurement of an alignment error). That is, if a second type shot region (more specifically, a shot region that has not allowed the use of a predetermined number of alignment marks for the measurement of an alignment error) occurs, the controller CNT may determine a shot region to be subjected to imprint processing next as a shot region having a predetermined number of alignment marks.

In step S609, the controller CNT unloads the substrate S from the substrate stage SS by controlling a transfer mechanism (not shown). In step S610, the controller CNT determines whether there is any unprocessed substrate S. If there is any unprocessed substrate S, the process returns to step S602; otherwise, the controller CNT terminates the imprint method shown in Fig. 6.

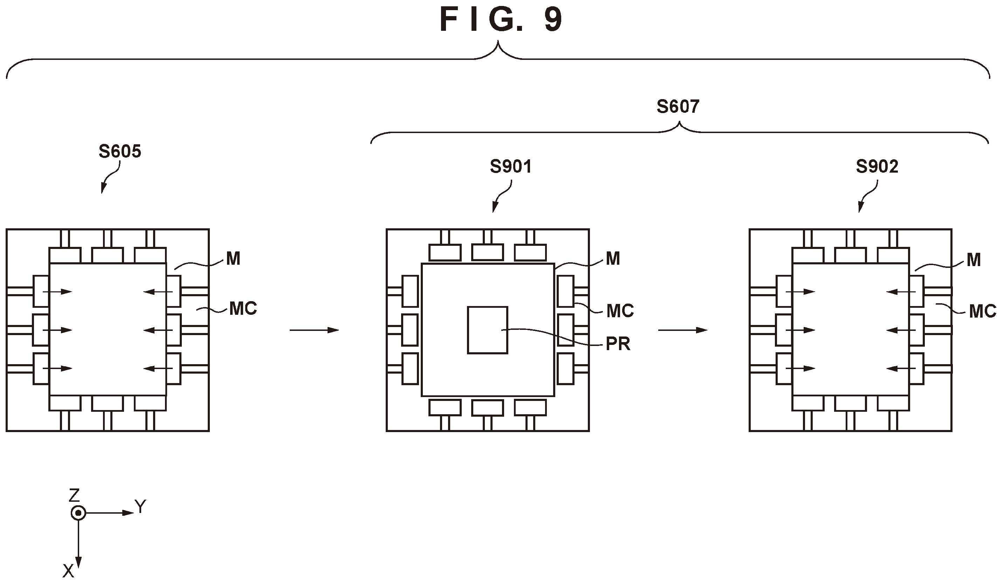

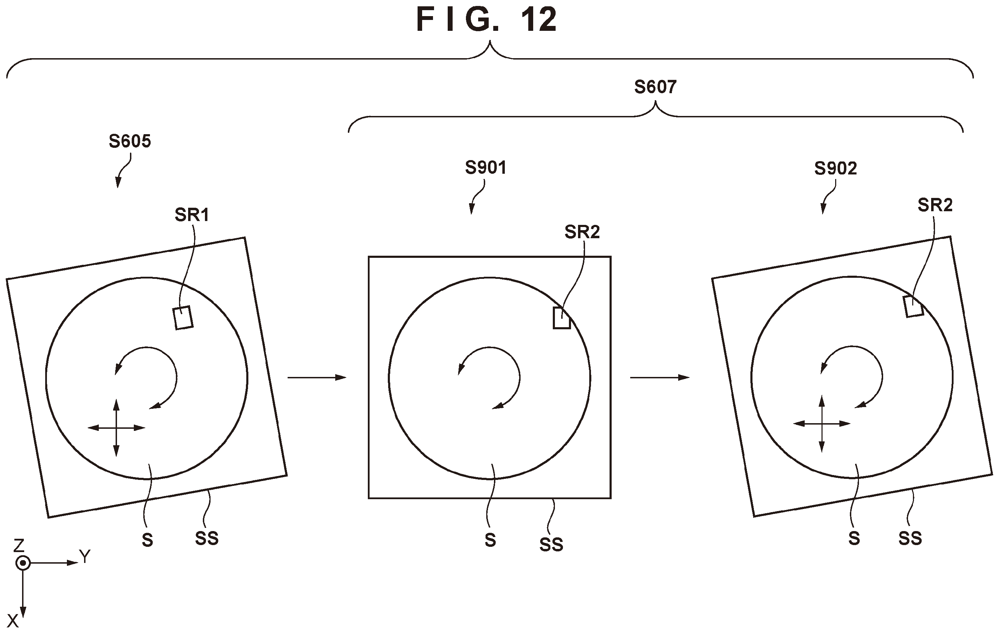

Two control examples in step S605 (the first imprint step) and step S607 (the second imprint step) will be described below. The first control example will be described first with reference to Figs. 9 and 12. In the first control example, the controller CNT stores, in the memory MEM, the final first correction command value group applied to the correction mechanism MC to reduce the alignment error in imprint processing for the first type shot region SR1 in step S605 (the first imprint step). In the first control example, the controller CNT stores, in the memory MEM, the final second correction command value group applied to the substrate driving mechanism SD to reduce the alignment error in imprint processing for the first type shot region SR1 in step S605. The second correction command value group can include the second correction command value concerning each of the rotation, the X direction, and the Y direction of the substrate stage SS.

In first step S901 in step S607 (the second imprint step), the controller CNT returns the state of the correction mechanism MC to the initial state. In addition, in first step S901 in step S607, the controller CNT returns the correction value for the rotation of the substrate S by the substrate driving mechanism SD to 0 and returns the correction values for the X direction and the Y direction to 0. In second step S902 in step S607, the controller CNT deforms the pattern region PR of the mold M so as to reduce the alignment error by applying the first correction command value group stored in the memory MEM in at least the latest step S605 to the correction mechanism MC. In the second step in step S607, the controller CNT corrects the rotation of the substrate S and the positions in the X direction and the Y direction so as to reduce the alignment error by applying the second correction command value group stored in the memory MEM in at least the latest step S605 to the substrate driving mechanism SD.

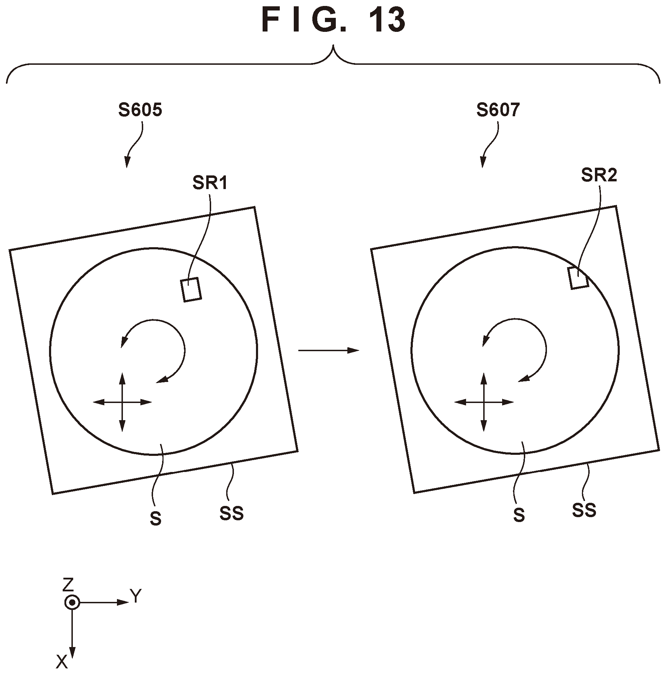

The second control example will be described next with reference to Figs. 10 and 13. In the second control example, the controller CNT stores, in the memory MEM, the final first correction command value group applied to the correction mechanism MC so as to reduce the alignment error in imprint processing for the first type shot region SR1 in step S605 (the first imprint step). In step S605 (the first imprint step), the controller CNT stores, in the memory MEM, the final second correction command value group applied to the substrate driving mechanism SD to reduce the alignment error in imprint processing for the first type shot region SR1.

In step S607 (the second imprint step), the controller CNT maintains the final first correction command value group applied to the correction mechanism MC in step S605 (the first imprint step) without returning the state of the correction mechanism MC to the initial state. In addition, in step S607, the controller CNT maintains the final second correction command value group concerning rotation applied to the substrate driving mechanism SD in step S605 (the first imprint step) without returning the rotation of the substrate S to 0 by the substrate driving mechanism SD. In addition, in step S607, the controller CNT corrects the positions of the substrate S in the X direction and the Y direction so as to reduce the alignment error by applying, to the substrate driving mechanism SD, the second command values concerning the X direction and the Y direction stored in the memory MEM in at least latest step S605.

In one aspect, in step S607, imprint processing can be performed using the alignment error obtained in at least latest step S605 with respect to a component other than the components of the alignment error obtained by using usable alignment marks for a shot region classified as a second type shot region (more specifically, the alignment error between the shot region and the pattern region). For example, in step S607, the controller CNT can use the alignment error obtained in at least latest step S605 with respect to a rotation component and a shape component and use the alignment error obtained from the second type shot region with respect to a shift component. Alternatively, in step S607, the controller CNT can use the alignment error obtained in at least latest step S605 with respect to a rotation component and use the alignment error obtained from the second type shot region with respect to another component. Alternatively, in step S607, the controller CNT can use the alignment error obtained in at least latest step S605 with respect to a rotation component and a magnification component and use the alignment error obtained from the second type shot region with respect to another component.

Several embodiments will be described below as modifications or concrete examples of the first embodiment.

### (Second Embodiment)

In the second embodiment, the predetermined number of alignment marks based on which it is determined whether a shot region is a first type shot region or second type shot region is three.

In the second embodiment, in a case where the number of alignment marks that can be used for a shot region SR as a processing target is two, step S607 (the second imprint step) is executed. In this case, in step S607, a controller CNT performs alignment concerning a shift component and a rotation component based on the result of measuring the alignment error between the shot region SR classified as a second type shot region and a pattern region PR. In step S607, the controller CNT performs alignment concerning a deformation component based on the alignment error obtained in at least latest step S605 (the first imprint step). In this case, it is possible to perform alignment concerning a deformation component based on the above first correction command value group.

In the second embodiment, even in a case where the number of alignment marks that can be used for the shot region SR as a processing target is one, step S607 (the second imprint step) is executed. In this case, in step S607, the controller CNT performs alignment concerning a shift component based on the result of measuring the alignment error between the shot region SR classified as a second type shot region and the pattern region PR. In addition, in step S607, the controller CNT performs alignment concerning a rotation component and a deformation component based on the alignment error obtained in at least latest step S605 (the first imprint step). In this case, it is possible to perform alignment concerning a rotation component based on the second correction command values concerning the rotation component described above. It is also possible to perform alignment concerning a deformation component based on the first correction command value group described above.

### (Third Embodiment)

In the third embodiment, at least the latest first imprint steps are the latest two or more first imprint steps. That is, in the second imprint step, the alignment error obtained in the two or more latest first imprint steps is used as the alignment error obtained in at least the latest first imprint step. For example, in the second imprint step, imprint processing is executed so as to reduce the alignment error between a second type shot region and a pattern region PR based on the transition of the displacement amount of the mold obtained from the alignment error in past imprint processing. In this case, the displacement amount of the mold can be evaluated as the shift amount (the shift amounts in the X direction and the Y direction) between a shot region SR and the pattern region PR of a mold M. A controller CNT can store, in a memory MEM, the shift amount (the shift amounts in the X direction and the Y direction) obtained in an alignment step in each first imprint step (step S605) as the first correction command value group. The controller CNT can refer to a plurality of first correction command value groups (the displacement amounts of the mold) stored in the memory MEM in the second imprint step (step S607) executed after a plurality of first imprint steps. The controller CNT can execute imprint processing so as to reduce the alignment error between the shot region (the second type shot region) and the pattern region PR based on the transition of a plurality of first correction command value groups (the displacement amounts of the mold) stored in the memory MEM. For example, the controller CNT can estimate the current displacement amount of the mold based on the transition of a plurality of first correction command value groups (the displacement amounts of the mold) stored in the memory MEM. Accordingly, the controller CNT can execute imprint processing so as to reduce the alignment error between the second type shot region and the pattern region PR based on the estimation.

### (Fourth Embodiment)

The second imprint step (S607) may be executed for two or more second shot regions between the first imprint step (step S605) and the first imprint step (step S605). In this case, a controller CNT can use the same first correction command value group in the second imprint step (step S607) for two or more second shot regions. The controller CNT may limit the number of second shot regions for which the second imprint step is continuously executed. In this case, in step S606, the controller CNT can change the sequence of imprint processing for an unprocessed shot region so as to inhibit the number of second shot regions for which the second imprint step is continuously executed from exceeding a specified number.

### (Article Manufacturing Method)

An article manufacturing method of manufacturing an article by applying the imprint apparatus 1 or the imprint method described above will be described below. The imprint apparatus 1 or the imprint method described above can perform imprint processing with high alignment accuracy for a second type shot region. This is advantageous in manufacturing a high-quality article. The article manufacturing method includes a pattern formation step of forming a pattern on a substrate by the imprint apparatus 1 or the imprint method described above and a processing step of obtaining an article by processing the substrate on which the pattern is formed. The processing step includes, for example, an etching step, a dicing step, and a sealing step.

The pattern of a cured product formed using an imprint apparatus is used permanently for at least some of various kinds of articles or temporarily when manufacturing various kinds of articles. The articles are an electric circuit element, an optical element, a MEMS, a recording element, a sensor, a mold, and the like. Examples of the electric circuit element are volatile and nonvolatile semiconductor memories such as a DRAM, an SRAM, a flash memory, and an MRAM and semiconductor elements such as an LSI, a CCD, an image sensor, and an FPGA. The mold includes an imprint mold or the like.

The pattern of the cured product is directly used as at least some of the constituent members of the above-described articles or used temporarily as a resist mask. After etching or ion implantation is performed in the substrate processing step, the resist mask is removed.

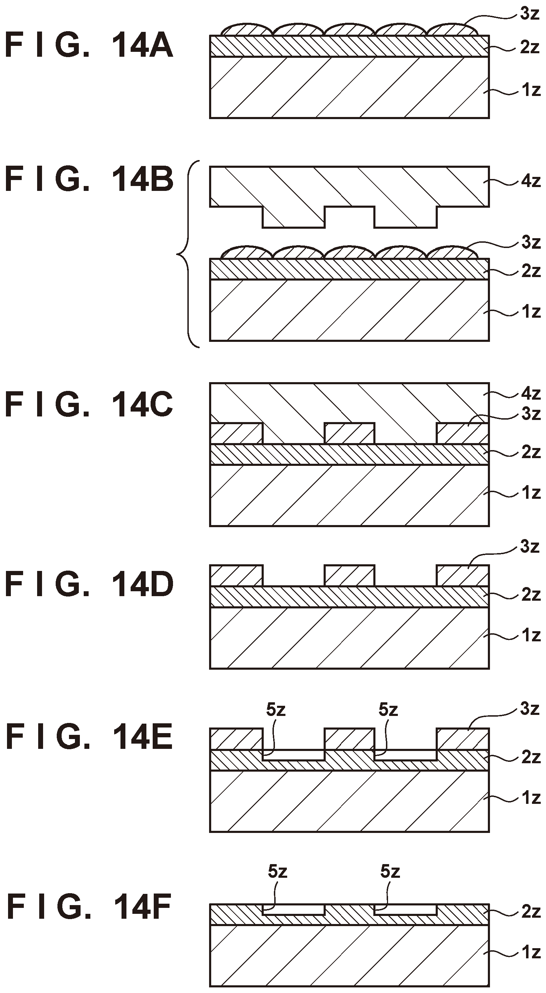

An article manufacturing method in which an imprint apparatus forms a pattern on a substrate, processes the substrate on which the pattern is formed, and manufactures an article from the processed substrate will be described next. As shown in Fig. 14A, a substrate 1z such as a silicon wafer with a processed material 2z such as an insulator formed on the surface is prepared. Next, an imprint material 3z is applied to the surface of the processed material 2z by an inkjet method or the like. A state in which the imprint material 3z is applied as a plurality of droplets onto the substrate is shown here.

As shown in Fig. 14B, a side of a mold 4z for imprint with a concave-convex pattern is directed toward and made to face the imprint material 3z on the substrate. As shown in Fig. 14C, the substrate 1z to which the imprint material 3z is applied is brought into contact with the mold 4z, and a pressure is applied. The gap between the mold 4z and the processed material 2z is filled with the imprint material 3z. In this state, when the imprint material 3z is irradiated with light as energy for curing via the mold 4z, the imprint material 3z is cured.

As shown in Fig. 14D, after the imprint material 3z is cured, the mold 4z is separated from the substrate 1z, and the pattern of the cured product of the imprint material 3z is formed on the substrate 1z. In the pattern of the cured product, the concave portion of the mold corresponds to the convex portion of the cured product, and the convex portion of the mold corresponds to the concave portion of the cured product. That is, the concave-convex pattern of the mold 4z is transferred to the imprint material 3z.

As shown in Fig. 14E, when etching is performed using the pattern of the cured product as an etching resistant mask, a portion of the surface of the processed material 2z where the cured product does not exist or remains thin is removed to form a groove 5z. As shown in Fig. 14F, when the pattern of the cured product is removed, an article with the grooves 5z formed in the surface of the processed material 2z can be obtained. Here, the pattern of the cured product is removed. However, instead of removing the pattern of the cured product after the process, it may be used as, for example, an interlayer dielectric film included in a semiconductor element or the like, that is, a constituent member of an article.

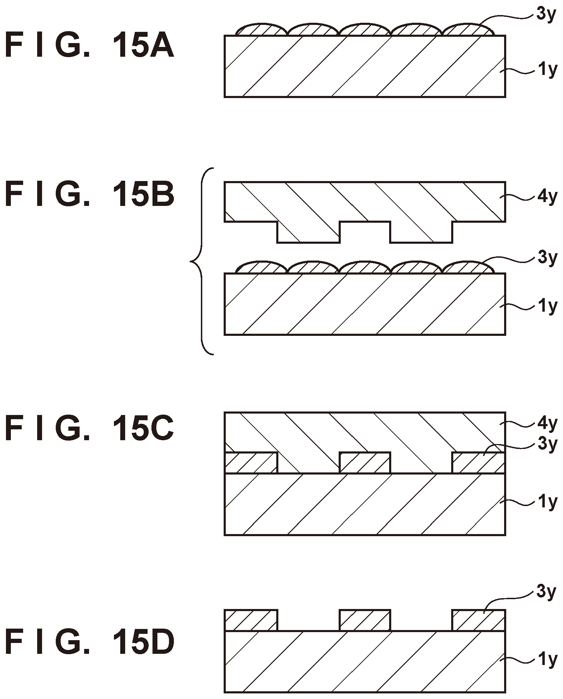

Another article manufacturing method will be described next. As shown in Fig. 15A, a substrate 1y such as silica glass is prepared. Next, an imprint material 3y is applied to the surface of the substrate 1y by an inkjet method or the like. A layer of another material such as a metal or a metal compound may be provided on the surface of the substrate 1y.

As shown in Fig. 15B, a side of a mold 4y for imprint with a concave-convex pattern is directed toward and made to face the imprint material 3y on the substrate. As shown in Fig. 15C, the substrate 1y to which the imprint material 3y is applied is brought into contact with the mold 4y, and a pressure is applied. The gap between the mold 4y and the substrate 1y is filled with the imprint material 3y. In this state, when the imprint material 3y is irradiated with light via the mold 4y, the imprint material 3y is cured.

As shown in Fig. 15D, after the imprint material 3y is cured, the mold 4y is separated from the substrate 1y, and the pattern of the cured product of the imprint material 3y is formed on the substrate 1y. Thus, an article including the pattern of the cured product as a constituent member can be obtained. Note that when the substrate 1y is etched using the pattern of the cured product as a mask in the state shown in Fig. 15D, an article with the concave and convex portions reversed with respect to the mold 4y, for example, an imprint mold can be obtained.

Various embodiments have been described in detail above but it will be understood that the present disclosure is not limited to these embodiments and encompasses all modifications, variants, alternatives and equivalents falling within the scope of the appended claims.

## Claims

1. An imprint method of performing imprint processing by using a mold for each shot region of a substrate having a plurality of shot regions that can be classified into a first type shot region enabling use of a predetermined number of alignment marks and a second type shot region disabling use of the predetermined number of alignment marks, the method comprising:
controlling a sequence of the imprint processing for the plurality of shot regions so as to alternately execute the imprint processing for at least one of the first type shot region and the imprint processing for at least one of the second type shot region;
performing a first imprint process of measuring a first alignment error, with respect to a first shot region classified as the first type shot region, between the shot region and a pattern region of the mold by using the predetermined number of alignment marks and performing the imprint processing based on the alignment error; and
performing a second imprint process of performing the imprint processing for a second shot region classified as the second type shot region based on a result of measuring a second alignment error between the second shot region and the pattern region by using usable alignment marks and the first alignment error obtained in at least the latest first imprint process.

2. The method according to claim 1, wherein the first type shot region includes a shot region having a rectangular shape, and the second type shot region includes a shot region having a shape including an arc along an edge of the substrate.

3. The method according to claim 1, wherein the second type shot region includes a shot region that has disabled use of the predetermined number of alignment marks for measurement of an alignment error.

4. The method according to claim 3, wherein in the controlling the sequence of the imprint processing, the sequence of the imprint processing is controlled so as to execute the imprint processing for a shot region having the predetermined number of alignment marks next to the imprint processing for the second type shot region.

5. The method according to claim 4, wherein in the controlling the sequence of the imprint processing, the sequence of the imprint processing for the plurality of shot regions is controlled in accordance with a predetermined tentative sequence, and
in a case where the second type shot region occurs, a shot region subjected to the imprint processing next is set as a shot region having the predetermined number of alignment marks.

6. The method according to any one of claims 1 to 5, wherein each of the predetermined number of alignment marks includes a first mark for detection of an alignment error in a first direction and a second mark for detection of an alignment error in a second direction orthogonal to the first direction, and
the predetermined number of alignment marks is three.

7. The method according to claim 6, wherein in a case where the number of usable alignment marks is two, in the performing the second imprint process, alignment concerning a shift component and a rotation component is performed based on a result of measuring the second alignment error between the second shot region and the pattern region, and alignment concerning a deformation component is performed based on the first alignment error obtained in at least the latest first imprint process.

8. The method according to claim 6, wherein in a case where the number of usable alignment marks is one, in the performing the second imprint process, alignment concerning a shift component is performed based on a result of measuring the second alignment error between the second shot region and the pattern region, and alignment concerning a rotation component and a deformation component is performed based on the first alignment error obtained in at least the latest first imprint process.

9. The method according to any one of claims 1 to 6, wherein in the performing the second imprint process, the imprint processing is performed concerning a component other than a component of the second alignment error between the shot region and the pattern region which is obtained by using usable alignment marks with respect to the second shot region classified as the second type shot region by using the first alignment error obtained in at least the latest first imprint process.

10. The method according to any one of claims 1 to 8, wherein in the performing the second imprint process, the first alignment error obtained in the latest not less than two first imprint processes is used as the first alignment error obtained in at least the latest first imprint process.

11. The method according to any one of claims 1 to 10, wherein in the performing the first imprint process and the performing the second imprint process, the imprint processing is executed so as to reduce an alignment error between a shot region subjected to the imprint processing and the pattern region.

12. The method according to any one of claims 1 to 10, wherein in the performing the second imprint process, the imprint processing is executed so as to reduce the second alignment error between the second shot region classified as the second type shot region and the pattern region based on a transition of a displacement amount of the mold which is obtained from the first alignment error in past imprint processing.

13. An imprint method of performing imprint processing for each shot region of a substrate by using a mold, the method comprising:
determining whether a shot region to be subjected to the imprint processing next is a first type shot region enabling use of a predetermined number of alignment marks or a second type shot region disabling use of the predetermined number of alignment marks;
performing a first imprint process of measuring a first alignment error, concerning a first shot region determined as the first type shot region in the determining, between the first shot region and a pattern region of the mold by using the predetermined number of alignment marks and performing the imprint processing based on the first alignment error; and
performing a second imprint process of performing the imprint processing for a second shot region determined as the second type shot region in the determining based on a result of measuring a second alignment error between the second shot region and the pattern region by using usable alignment marks and the first alignment error obtained in at least the latest first imprint process.

14. The method according to claim 13, wherein the first type shot region includes a shot region having a rectangular shape, and the second type shot region includes a shot region having a shape including an arc along an edge of the substrate.

15. The method according to claim 13, wherein the second type shot region includes a shot region that has disabled use of the predetermined number of alignment marks for measurement of an alignment error.

16. The method according to any one of claims 13 to 15, wherein each of the predetermined number of alignment marks includes a first mark for detection of an alignment error in a first direction and a second mark for detection of an alignment error in a second direction orthogonal to the first direction, and
the predetermined number of alignment marks is three.

17. The method according to claim 16, wherein in a case where the number of usable alignment marks is two, in the performing the second imprint process, alignment concerning a shift component and a rotation component is performed based on a result of measuring an alignment error between the second type shot region and the pattern region, and alignment concerning a deformation component is performed based on the alignment error obtained in at least the latest first imprint process.

18. The method according to claim 16, wherein in a case where the number of usable alignment marks is one, in the performing the second imprint process, alignment concerning a shift component is performed based on a result of measuring an alignment error between the second type shot region and the pattern region, and alignment concerning a rotation component and a deformation component is performed based on the alignment error obtained in at least the latest first imprint process.

19. The method according to any one of claims 13 to 16, wherein in the performing the second imprint process, the imprint processing is performed concerning a component other than a component of an alignment error between the shot region and the pattern region which is obtained by using usable alignment marks with respect to a shot region classified as the second type shot region by using the alignment error obtained in at least the latest first imprint process.

20. The method according to any one of claims 13 to 16, wherein in the performing the second imprint process, the alignment error obtained in the latest not less than two first imprint processes is used as the alignment error obtained in at least the latest first imprint process.

21. The method according to any one of claims 13 to 20, wherein in the performing the first imprint process and the performing the second imprint process, the imprint processing is executed so as to reduce an alignment error between a shot region subjected to the imprint processing and the mold.

22. The method according to any one of claims 13 to 20, wherein in the performing the second imprint process, the imprint processing is executed so as to reduce an alignment error between a shot region classified as the second type shot region and the pattern region based on a transition of a displacement amount of the pattern region which is obtained from the alignment error in the past imprint processing.

23. An imprint apparatus that performs imprint processing by using a mold for each shot region of a substrate having a plurality of shot regions that can be classified into a first type shot region enabling use of a predetermined number of alignment marks and a second type shot region disabling use of the predetermined number of alignment marks, the apparatus comprising:
a controller configured to control the imprint processing; and
an alignment scope configured to measure an alignment error between a selected shot region of the substrate and a pattern region of the mold,
wherein the controller controls a sequence of the imprint processing for the plurality of shot regions so as to alternately execute the imprint processing for at least one of the first type shot region and the imprint processing for at least one of the second type shot region,
controls a first imprint process of measuring a first alignment error, with respect to a first shot region classified as the first type shot region, between the first shot region and the pattern region by using the predetermined number of alignment marks by using the alignment scope and performing the imprint processing based on the first alignment error, and
controls a second imprint process of performing the imprint processing for a second shot region classified as the second type shot region based on a result of measuring a second alignment error between the second shot region and the pattern region by using usable alignment marks with the alignment scope and the first alignment error obtained in at least the latest first imprint process.

24. An imprint apparatus that performs imprint processing for each shot region of a substrate by using a mold, the apparatus comprising:
a controller configured to control the imprint processing; and
an alignment scope configured to measure an alignment error between a selected shot region of the substrate and a pattern region of the mold,
wherein the controller determines whether a shot region to be subjected to the imprint processing next is a first type shot region enabling use of a predetermined number of alignment marks or a second type shot region disabling use of the predetermined number of alignment marks;
controls a first imprint process of measuring a first alignment error, concerning a first shot region determined as the first type shot region, between the first shot region and the pattern region by using the predetermined number of alignment marks with the alignment scope and performing the imprint processing based on the first alignment error, and
controls a second imprint process of performing the imprint processing for a second shot region determined as the second type shot region based on a result of measuring a second alignment error between the second shot region and the pattern region by using usable alignment marks with the alignment scope and the first alignment error obtained in at least the latest first imprint process.

25. An article manufacturing method comprising:
forming a pattern on a substrate by using the imprint method according to any one of claim 1 to 22; and
obtaining an article by processing the substrate on which the pattern is formed.
